# EUROPÄISCHE PATENTSCHRIFT

(11) **EP 0 982 862 B1**
(45) Veröffentlichungstag und Bekanntmachung des Hinweises auf die Patenterteilung: **07.04.2010**
(21) Anmeldenummer: 99112641.8
(22) Anmeldetag: 02.07.1999
(51) Int. Cl.: H03K 3/30, H02M 7/5383

(54) **Widerstandsarme Bipolar-Brückenschaltung**
Bipolar bridge circuit without resistors
Circuit bipolaire en pont sans résistances

(30) Priorität: 26.08.1998 DE 19838829
(43) Veröffentlichungstag der Anmeldung: 01.03.2000
(73) Patentinhaber: Osram Gesellschaft mit beschränkter Haftung, 81543 München (DE)
(72) Erfinder: Franck, Felix, Dr., 80333 München (DE)
(74) Vertreter: Raiser, Franz

(56) Entgegenhaltungen:
- DE-A- 19 728 295
- US-A- 4 307 353
- US-A- 5 214 356

## Beschreibung

### Technisches Gebiet

Die vorliegende Erfindung bezieht sich auf eine Betriebsschaltung für eine Last, insbesondere eine Niederdruckentladungslampe. Dabei geht die Erfindung aus von einer Oszillatorschaltung zum Hochfrequenzbetrieb der Last, die einerseits von einer Spannung mit dominantem Gleichanteil versorgt wird und andererseits durch eine Brückenschaltung die Hochfrequenzleistungsversorgung der Last, also insbesondere der Lampe, bildet.

### Stand der Technik

Aus verschiedenen technischen Gründen werden bei solchen Oszillatorschaltungen häufig Bipolartransistorbrücken verwendet. Durch entsprechend gesteuertes Aus- und Einschalten der Basen der Bipolartransistoren entsprechend der Arbeitsfrequenz der Brückenschaltung werden an entsprechenden Abgriffspunkten der Brückenschaltung Hochfrequenzversorgungspotentiale erzeugt. Dies wird - allgemein gesprochen - von einer Schaltsteuereinrichtung übernommen, wobei mit einer von außen vorgegebenen Sollfrequenz genauso gearbeitet werden kann wie mit einer Rückkopplungskonstruktion, die zu einer freien Schwingung der Brückenschaltung führt.

Dabei haben sich verschiedene Schwierigkeiten ergeben. So werden konventionell die Basen der Bipolartransistoren mit einem großen Strompuls angesteuert und stark gesättigt, so dass sich die Einschaltzeit durch die Speicherzeit des Bipolartransistors ergibt. Die entsprechenden Aufsteuerströme führen zu hohen Verlusten in den Basisanschlussleitungen und/oder in konventionell üblichen Basiswiderständen sowie im Bipolartransistor selbst. Ferner ergibt sich eine starke Abhängigkeit des Ausschaltzeitpunkts von der Speicherzeit des jeweiligen Bipolartransistors. Die Bipolartransistoren müssen dabei also zur Einhaltung bestimmter Spezifikationen sorgfältig selektiert werden.

In der US-A-5 214 356 ist eine Oszillatorschaltung zum Betreiben einer Last mit einer Bipolartransistorbrücke und einer Schaltsteuereinrichtung in Form eines Steuertransformators zur Ansteuerung der Basen der Bipolartransistoren über eine jeweilige Basisanschlussleitung aufgeführt, wobei ein Basisserienkondensator auf der transistorabgewandten Seite des Steuertransformators in eine zur Basisanschlussleitung in Serie liegende Anschlussleitung des Steuertransformators zu einem Abgriff bzw. Versorgungspotential der Bipolartransistorbrücke geschaltet ist.

Der Basisserienkondensator dient beim Betrieb der Schaltung zur Speicherung einer Spannung zum Ausschalten des jeweiligen Transistors. Ein NPN-Transistor wird also z.B. mit negativer Emitterbasisspannung ausgeschaltet; die Ansteuerung der Schalttransistoren der Brückenschaltung ist dementsprechend verlustoptimiert.

In der Basisanschlussleitung zwischen dem Steuertransformator und dem Bipolartransistor und auf der transistorabgewandten Seite in der Anschlussleitung seriell zu dem Basisserienkondensator liegen außerdem keine Halbleiterbauelemente wie Halbleiterschalter. Damit können inhärente Verluste dieser Bauelemente, unerwünschte parasitäre Effekte sowie ein nachteiliger Anstieg der Herstellungskosten der Schaltung vermieden werden. Insbesondere erübrigt es sich, die Schalttransistoren stark im Sättigungsbereich zu betreiben. Vielmehr werden sie nur leicht über ihrer Sättigung betrieben, wodurch sie besser auf die Ansteuerung durch die Schaltsteuereinrichtung zusammen mit dem Basisserienkondensator reagieren. Der Einfluss der Speicherzeit des betreffenden Bipolartransistors wird dadurch erheblich zurückgedrängt. Die bereits erwähnte aufwendige Selektierung der Transistoren ist somit nur noch in geringerem Umfang bzw. nicht mehr notwendig.

### Darstellung der Erfindung

Der Erfindung liegt nun das technische Problem zugrunde, die Betriebseigenschaften der obigen Oszillatorschaltungen insbesondere im Hinblick auf ihre Verluste weiter zu verbessern.

Erfindungsgemäß wird das Problem bei einer Oszillatorschaltung zum Betreiben einer Last mit einer Bipolartransistorbrücke und einer Schaltsteuereinrichtung in Form eines Steuertransformators zur Ansteuerung der Basen der Bipolartransistoren über eine jeweilige Basisanschlussleitung, wobei ein Basisserienkondensator in eine der Basisanschlussleitungen zwischen dem Steuertransformator und einem der Bipolartransistoren oder auf der transistorabgewandten Seite des Steuertransformators in eine dazu in Serie liegenden Anschlussleitung des Steuertransformators zu einem Abgriff oder einem Versorgungspotential der Bipolartransistorbrücke geschaltet ist und in der Basisanschlussleitung zwischen dem Steuertransformators und dem Bipolartransistor der auf der transistorabgewandten Seite in der Anschlussleitung seriell zu dem Basisserienkondensator keine Halbleiterbauelemente, insbesondere Halbleiterschalter, liegen, dadurch gelöst, dass parallel zu der Serienschaltung aus Basisserienkondensator und Steuertransformator oder parallel zu dem Basisserienkondensator allein ein Parallelwiderstand liegt.

Durch den zu dem Basisserienkondensator parallelliegenden Parallelwiderstand wird der dem Basisserienkondensator entnommene Aufsteuerstrom in den Arbeitsperioden der Schaltung mit Ausschaltung des betreffenden Bipolartransistors (zur Herstellung einer ausgeglichenen Strom- bzw. Ladungsbilanz) auszugleichen. Der Parallelwiderstand kann dabei auch parallel zur Serienschaltung aus Basiskondensator und Schaltsteuereinrichtung liegen, wenn die Schaltsteuereinrichtung auf der transistorabgewandten Seite mit der Brückenschaltung verbunden ist. Der Parallelwiderstand ist bevorzugt gleichzeitig auch konventioneller Basisschutzwiderstand. Ein günstiger Bereich für seinen Wert liegt zwischen 100 und 1000 Ω.

Ein weiterer Aspekt hierbei ist eine Ausführung des Parallelwiderstandes durch einen steuerbaren, etwa einen temperaturabhängigen Widerstand. Damit ist es möglich, den Temperaturgang der Schaltfrequenz der Oszillatorschaltung zu begradigen.

Eine weitere Möglichkeit ist ein direkt steuerbarer Widerstand. In Frage kommen Bipolar- oder MOS-Transistoren im linearen Arbeitsbereich. Obwohl die Oszillatorschaltung dabei weiterhin eine freischwingende Schaltung bleiben kann, ist so eine aktive Beeinflussung der Frequenz von außen möglich. Schließlich ist dabei aber auch die Verwendung eines Optokopplers als direkt steuerbarer Widerstand denkbar.

Es ist darüber hinaus bevorzugt, dass in der Basisanschlussleitung sowie auf der transistorabgewandten Seite der Schaltsteuereinrichtung auch keine Ohm'schen Widerstände liegen. Damit sind natürlich keine parasitären Widerstände, sondern nur bewusst in der Auslegung eingeplante, insbesondere diskrete, Widerstände gemeint. Damit reduzieren sich nicht nur weiter die Verluste im Oszillatorschaltungsbetrieb, sondern auch die durch Ohm'sche Widerstände in Verbindung mit den unvermeidlichen parasitären Kapazitäten, vor allem des Transistors selbst, verbundenen Speicherzeiten. Wie schon zuvor bezieht sich der Begriff Basisanschlussleitung auf die Leitungsstrecke zwischen der Schaltsteuereinrichtung und dem entsprechenden Bipolartransistor der Brückenschaltung und der Begriff Anschlussleitung (auf der transistorabgewandten Seite) auf die Leitungsstrecke zwischen der Schaltsteuereinrichtung und der Brücke selbst, d.h. einem der Abgriffe oder Versorgungspotentiale.

Bevorzugt ist es ferner, dass auch die Emitterstrecken jeweils frei von Ohm'schen Widerständen sind, d.h. die Leitungsstrecken zwischen dem Emitter des jeweiligen Bipolartransistors und dem entsprechenden nächsten Abgriff oder Versorgungspotential der Brückenschaltung. Dadurch reduzieren sich wiederum die Verluste und die RC-Speicherzeiten. Solche Emitterwiderstände sind im Stand der Technik häufig, und zwar u.a. um in Verbindung mit einem der Emitterbasisstrecke parallelgeschalteten Basisschutzwiderstand einen positiven Rückkopplungseffekt beim Ausschalten über das von dem Basisschutzwiderstand abgegriffene und sich wegen des Emitterwiderstands beim Ausschalten schnell verändernde Potential zwischen Emitterwiderstand und Emitter zu erzielen. Durch die Schaltsteuereinrichtung in Verbindung mit dem erfindungsgemäßen Basisserienkondensator ist diese Maßnahme überflüssig.

Aus den bereits geschilderten Gründen der Verminderung von Verlusten und Impedanzspeicherzeiten liegen bevorzugterweise in der Basisanschlussleitung und in der Anschlussleitung der Schaltsteuereinrichtung auch keine Induktivitäten (außer parasitären). Gemäß einer weiteren Ausführungsform ist ein zusätzlicher Kondensator zwischen den Basisanschlussleitungen, ein sogenannter Basisbrückenkondensator, vorgesehen. Er hat die Funktion, die sogenannte Kollektor-Vorstromspitze zu vermeiden und einen schädlichen Brückenkurzschluss auszuschließen, er kommt also der zeitgenauen Schaltsteuerung und der Schaltentlastung zugute. Er kann z.B. eine Kapazität von 100 bis 220 pF haben. Zu der Funktionsweise eines solchen Basisbrückenkondensators wird einerseits auf das Ausführungsbeispiel in dieser Anmeldung und des weiteren auf die Parallelanmeldung derselben Anmelderin mit dem Aktenzeichen DE 197 28 295.4 verwiesen. Insbesondere wird der Offenbarungsgehalt der Parallelanmeldung zur Funktionsweise, Verschaltung und bevorzugten Dimensionierung des Basisbrückenkondensators hiermit durch Inbezugnahme in diese Anmeldung aufgenommen.

Die oben bereits erwähnte kleinere Auslegung des Aufsteuerstroms bei der Erfindung (im Vergleich zur starken Sättigung im Stand der Technik) liegt bevorzugt im Bereich des 1,5- bis 3-fachen desjenigen minimalen Aufsteuerstroms, bei dem der Bipolartransistor gerade gesättigt wird.

Die Erfindung kann insbesondere angewendet werden bei Halbbrückenoszillatorschaltungen aus Bipolartransistoren, wie sie vor allem zum Betrieb von Niederdruckentladungslampen eingesetzt werden können. Dabei wird bevorzugt als Schaltsteuereinrichtung ein Steuertransformator verwendet. Der Transformator ist in weiter bevorzugter Weise sättigend ausgelegt. Durch die Sättigung des Steuertransformators oder durch seinen Magnetisierungsstrom - je nach Strom in der lampenseriellen Lastkreisinduktivität (bei einem Lampen-EVG) - und in Verbindung mit dem bereits beschriebenen Basisserienkondensator werden die Bipolartransistoren ausgeschaltet, wobei weitere Ohm'sche oder induktive Bauelemente nicht notwendig sind. Vielmehr speichern die Sekundärwicklungen des Steuertransformators ihre Ansteuerleistung als Spannung bzw. Ladung in dem betreffenden relativ großen Basisserienkondensator, der seinerseits für das Abschalten des Bipolartransistors mit entsprechender Basisemitterspannung (negativ bei NPN-, positiv bei PNP-Transistoren) sorgt. Bei leitender Basis des Bipolartransistors erfolgt die Aufmagnetisierung bzw. Sättigung der Sekundärwicklung des Steuertransformators.

Um die Bipolartransistorbasen entsprechend der eingangs erläuterten Funktionsweise der Erfindung nicht mit einem zu starken Aufsteuerstrom zu sättigen, wird erfindungsgemäß vorzugsweise ein Windungsverhältnis von der Primärwicklung zur Sekundärwicklung des Steuertransformators von 1 oder weniger gewählt. Dadurch wird der Sekundärstrom begrenzt.

Ein wichtiger Aspekt in diesem Zusammenhang ist, dass im Sättigungsbereich des beschriebenen Steuertransformators die Spannung am Basisserienkondensator, die sich gleichzeitig aus der durch den Primärwicklungsstrom induzierten Spannung in der Sekundärwicklung des Steuertransformators ergibt, proportional zur Arbeitsfrequenz der Oszillatorschaltung ist. Es ergibt sich also eine gleichläufige Kopplung zwischen der Laststromamplitude und der Arbeitsfrequenz. Durch eine geeignete Abstimmung des Lastkreises läßt sich damit erfindungsgemäß eine Leistungsgegenkopplung bis hin zu einer zumindest näherungsweisen Regelung auf konstante Leistung erreichen.

### Beschreibung der Zeichnungen

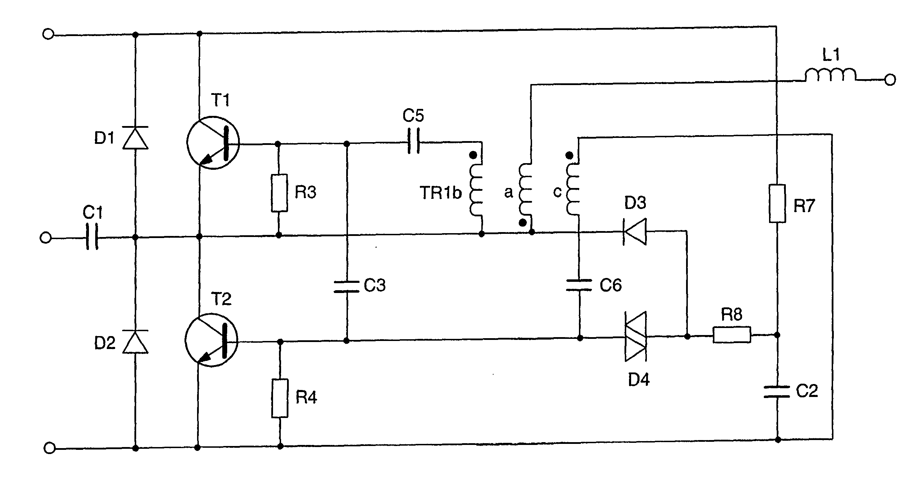

Weitere Einzelheiten und Merkmale der Erfindung ergeben sich aus der nun folgenden Beschreibung eines Ausführungsbeispiels und können jeweils für sich oder in beliebiger Kombination erfindungswesentlich sein. Das Ausführungsbeispiel ist in der Figur als vereinfachtes Schaltdiagramm illustriert.

An die beiden Anschlüsse am äußersten linken Rand des Schaltdiagramms ganz oben und ganz unten wird durch eine nicht weiter dargestellte Schaltung eine Versorgungsspannung mit dominantem Gleichanteil eingespeist, wobei oben das positive Versorgungspotential und unten das negative bzw. Masse liegt. Zwischen den beiden Versorgungspotentialzweigen erstreckt sich eine Halbbrücke aus zwei Bipolartransistoren T1 und T2, die jeweils eine dem Fachmann bekannte Freilaufdiode D1 bzw. D2 parallel zur Kollektoremitterstrecke aufweisen. An dem Mittenabgriff der Halbbrücke zwischen den beiden Bipolartransistoren T1 und T2 ergibt sich durch alternierendes Ein- und Ausschalten der Transistoren ein entsprechend zwischen den beiden Versorgungspotentialen oszillierendes Hochfrequenzpotential für die Last, hier für eine Niederdruckgasentladungslampe.

An dem Mittenabgriff der Halbbrücke greift ein mit C1 bezeichneter Trapezkondensator an, dessen anderer Anschluß mit einem der beiden Versorgungspotentiale verbunden ist. Es können auch zwei Trapezkondensatoren jeweils parallel zu einem Bipolartransistor T1 bzw. T2 vorgesehen sein. Die Funktion des Trapezkondensators C1 ist, den Potentialanstieg des Mittenabgriffs nach dem Ausschalten eines Bipolartransistors T1 bzw. T2 durch seine endliche Auflade- bzw. Entladezeit mit einer entsprechenden Flanke im Potentialzeitdiagramm abzuschrägen. Dies ist an sich bekannter Stand der Technik und wird hier nicht weiter dargestellt. Jedenfalls ergibt sich so eine verbesserte Schaltentlastung und elektromagnetische Verträglichkeit.

Der Mittenabgriff ist andererseits über eine Primärwicklung TR1a eines Steuertransformators TR1 und über eine Lastinduktivität L1 (Lampendrossel) mit einem Versorgungsanschluß der ansonsten nicht weiter dargestellten Niederdruckentladungslampe (mit bekannter Verschaltung) verbunden. Der andere Anschluß der Lampe kann über einen Koppelkondensator mit einem der beiden Versorgungspotentialzweige oder mit zwei Koppelkondensatoren an beiden Versorgungspotentialzweigen angeschlossen werden.

Eine positive Rückkopplung des Hochfrequenzlaststroms über den Steuertransformator TR1, d.h. über seine Sekundärwicklungen b und c, an die Basisanschlüsse der Bipolartransistoren T1, T2, führt zu einem freischwingenden Oszillationsbetrieb der Halbbrückenschaltung insgesamt. Dabei sorgt die durch die Punkte am Steuertransformator TR1 angedeutete Wicklungsorientierung für eine jeweils gegensinnige Strombeaufschlagung der Basen der Schalttransistoren T1, T2 der Halbbrücke.

Die Leitungsstrecke zwischen dem Steuertransformator TR1 und dem jeweiligen Basisanschluß führt jeweils über einen Basisserienkondensator C5 bzw. C6 zur Unterstützung der Ausschaltvorgänge des Bipolartransistors T1 bzw. T2 (durch eine negative Basisspannung wegen der Gleichspannungsentkopplung zum Steuertransformator). Diese Kondensatoren haben eine Kapazität von 1 bis 4,7 µF und erfordern nur eine geringe erforderliche Spannungsfestigkeit von etwa 20 V. Dabei kann die Reihenfolge der jeweiligen Sekundärwicklungen TR1b bzw. TR1c und des jeweiligen Basisserienkondensators C5 bzw. C6 einzeln oder beidseits vertauscht sein.

Zwischen dem jeweiligen Basisserienkondensator C5 bzw. C6 und der Basis des zugehörigen Bipolartransistors T1 bzw. T2 gibt es jeweils einen Abgriff, wobei beide Abgriffe durch einen Basisbrückenkondensator C3 von 100 pF bis 220 pF verbunden sind (es wird wiederum verwiesen auf das Ausführungsbeispiel der Parallelanmeldung DE 197 28 295.4, und zwar auch bezüglich der verschiedenen Verschaltungsmöglichkeiten dieses Basisbrückenkondensators C3). Der Basisbrückenkondensator C3 liegt potentialmäßig im wesentlichen zwischen dem Mittenabgriff der Halbbrücke und Masse. Dadurch bewirkt eine Potentialänderung des Mittenabgriffs seine Auf- bzw. Entladung in einer solchen Richtung, daß der als nächstes eingeschaltete Transistor erst nach Abschluß der Potentialänderung des Mittenabgriffs angesteuert wird.

Weiterhin sind zum Ausgleich der Strombilanz in den Basisserienkondensatoren C5 und C6 zwischen dem Mittenabgriff und der Basis des oberen Bipolartransistors T1 ein Widerstand R3 bzw. zwischen Masse und der Basis des unteren Bipolartransistors T2 ein Widerstand R4 vorgesehen. Ihr Wert liegt vorwiegend bei 470 Ω. Sie sorgen bei nichtleitfähiger Basis für einen Stromfluß dergestalt, daß trotz Gleichstromanteil im Basisstrom ein reiner Wechselstrom durch den betreffenden Basisserienkondensator C5 bzw. C6 fließt.

Dieser Wert von 470 Ω der Widerstände R3 und R4 ist deutlich höher als bei vergleichbaren konventionellen Basisschutzwiderständen. Der Wert reicht zur Herstellung einer ausgeglichenen Strombilanz im jeweiligen Basisserienkondensator C5 bzw. C6 aus, koppelt jedoch den Basisansteuerkreis nicht zu stark an den Mittenabgriff bzw. Masse an. Dabei ist zu beachten, daß die maximal zulässige Kollektoremitterspannung U_{CER} des jeweiligen Bipolartransistors T1 bzw. T2 (Kollektoremittermaximalspannung bei Verbindung von Basis und Emitter über einen nicht zu hochohmigen Widerstand R), die im Vergleich zur Spannungsfestigkeit mit offener Basis U_{CEO} wesentlich erhöht ist, ebenfalls durch die Verwendung dieser Parallelwiderstände R3 und R4 sichergestellt ist. Auch in dem in der Beschreibungseinleitung erwähnten Fall einer direkten Parallelschaltung des Basisserienkondensators C5 bzw. C6 und des zugehörigen Parallelwiderstands R3 bzw. R4 - d.h. der jeweils untere Anschluß des Parallelwiderstands läge zwischen Basisserienkondensator C5 bzw. C6 und zugehöriger Sekundärwicklung TR1b bzw. TR1c - ist diese Funktion erfüllt, weil die Sekundärwicklungen vergleichsweise niederohmig sind.

Weiterhin ist eine Anschwingschaltung eingezeichnet, und zwar mit dem Widerstand R7, der Diode D3, dem Diac D4 sowie dem Kondensator C2. Diese Schaltung ist erweitert um den Widerstand R8 (von 10 bis 22 Ω). Der technische Hintergrund ist die Notwendigkeit einer Strombegrenzung in dem Diac D4 und der Diode D3, die bei Betrieb der Bipolartransistorhalbbrücke T1, T2 die Spannung am Kondensator C2 sehr niedrig halten. Damit soll ein Zwischenzünden des Diac D4 im Betrieb unterbunden werden. Die Strombegrenzung durch den hinzugefügten Widerstand R8 ist insbesondere für die Funkentstörung wesentlich.

## Patentansprüche

1. Oszillatorschaltung zum Betreiben einer Last mit einer Bipolartransistorbrücke (T1, T2) und einer Schaltsteuereinrichtung in Form eines Steuertransformators (TR1) zur Ansteuerung der Basen der Bipolartransistoren (T1, T2) über eine jeweilige Basisanschlussleitung, wobei ein Basisserienkondensator (C5, C6) in eine der Basisanschlussleitungen zwischen dem Steuertransformator (TR1) und einem der Bipolartransistoren (T1, T2) oder auf der transistorabgewandten Seite des Steuertransformators (TR1) in eine dazu in Serie liegenden Anschlussleitung des Steuertransformators (TR1) zu einem Abgriff oder einem Versorgungspotential der Bipolartransistorbrücke (T1, T2) geschaltet ist und in der Basisanschlussleitung zwischen dem Steuertransformators (TR1) und dem Bipolartransistor (T1, T2) oder auf der transistorabgewandten Seite in der Anschlussleitung seriell zu dem Basisserienkondensator (C5, C6) keine Halbleiterbauelemente, insbesondere Halbleiterschalter, liegen, **dadurch gekennzeichnet, dass** parallel zu der Serienschaltung aus Basisserienkondensator (C5, C6) und Steuertransformator (TR1) oder parallel zu dem Basisserienkondensator (C5, C6) allein ein Parallelwiderstand (R3, R4) liegt.

2. Schaltung nach Anspruch 1, **dadurch gekennzeichnet, dass** der Basisserienkondensator (C5, C6) eine Kapazität von 1 µF bis 4,7 µF hat.

3. Schaltung nach Anspruch 1 oder 2, **dadurch gekennzeichnet, dass** in der Basisanschlussleitung zwischen dem Steuertransformator (TR1) und dem Bipolartransistor (T1, T2) oder auf der transistorabgewandten Seite in der Anschlussleitung seriell zu dem Basisserienkondensator (C5, C6) keine Ohm'schen Widerstände liegen.

4. Schaltung nach Anspruch 1, 2 oder 3, **dadurch gekennzeichnet, dass** in der Basisanschlussleitung zwischen dem Steuertransformator (TR1) und dem Bipolartransistor (T1, T2) oder auf der transistorabgewandten Seite in der Anschlussleitung seriell zu dem Basisserienkondensator (C5, C6) keine Induktivitäten liegen.

5. Schaltung nach einem der vorstehenden Ansprüche, **dadurch gekennzeichnet, dass** in einer Emitterstrecke eines Bipolartransistors (T1, T2) keine Ohm'schen Widerstände liegen.

6. Schaltung nach einem der vorstehenden Ansprüche, **dadurch gekennzeichnet, dass** die Basisanschlussleitungen der Bipolartransistoren (T1, T2), jeweils zwischen dem Steuertransformator (TR1) und dem Bipolartransistor (T1, T2) durch einen Basisbrückenkondensator (C3) miteinander verbunden sind.

7. Schaltung nach einem der vorstehenden Ansprüche, **dadurch gekennzeichnet, dass** der Basisbrückenkondensator (C3) eine Kapazität von 100 pF bis 220 pF hat.

8. Schaltung nach einem der vorstehenden Ansprüche, **dadurch gekennzeichnet, dass** der Aufsteuerstrom für die Basen der Bipolartransistoren (T1, T2) das 1,5- bis 3-fache des minimalen Aufsteuerstroms beträgt.

9. Schaltung nach einem der vorstehenden Ansprüche, **dadurch gekennzeichnet, dass** sich durch eine Laststromabhängigkeit der Arbeitsfrequenz der Bipolartransistorbrücke (T1, T2) eine Leistungsgegenkopplung der Schaltung ergibt.

10. Schaltung nach Anspruch 1, **dadurch gekennzeichnet, dass** der Parallelwiderstand (R3, R4) auch als Basisschutzwiderstand für den Bipolartransistor (T1, T2) wirkt.

11. Schaltung nach Anspruch 1, **dadurch gekennzeichnet, dass** der Parallelwiderstand (R3, R4) einen Wert von 100 Ω bis 1000 Ω hat.

12. Schaltung nach einem der vorstehenden Ansprüche, **dadurch gekennzeichnet, dass** die Bipolartransistorbrücke eine Halbbrücke (T1, T2) ist.

13. Schaltung nach Anspruch 1, **dadurch gekennzeichnet, dass** das Primärzu-Sekundär-Wicklungsverhältnis des Steuertransformators (TR1) kleiner oder gleich 1 ist.

## Claims

1. Oscillator circuit for operating a load with a bipolar transistor bridge (T1, T2) and a switching control device in the form of a control transformer (TR1) for driving the bases of the bipolar transistors (T1, T2), via a respective base connection line, a base series capacitor (C5, C6), being connected into one of the base connection lines between the control transformer (TR1) and one of the bipolar transistors (T1, T2) or on the transistor-remote side of the control transformer (TR1) into a connection line - situated in series herewith - of the control transformer (TR1) to a tap or a supply potential of the bipolar transistor bridge (T1, T2) and no semiconductor components, in particular semiconductor switches, being situated in the base connection line between the control transformer (TR1) and the bipolar transistor (T1, T2) or on the transistor-remote side in the connection line in series with the base series capacitor (C5, C6), **characterized in that** solely a parallel resistor (R3, R4), is situated in parallel with the series circuit comprising base series capacitor (C5, C6) and control transformer (TR1) or in parallel with the base series capacitor (C5, C6).

2. Circuit according to Claim 1, **characterized in that** the base series capacitor (C5, C6) has a capacitance of 1 µF to 4.7 µF.

3. Circuit according to Claim 1 or 2, **characterized in that** no ohmic resistances are situated in the base connection line between the control transformer (TR1) and the bipolar transistor (T1, T2) or on the transistor-remote side in the connection line in series with the base series capacitor (C5, C6).

4. Circuit according to Claim 1, 2 or 3, **characterized in that** no inductances are situated in the base connection line between the control transformer (TR1) and the bipolar transistor (T1, T2) or on the transistor-remote side in the connection line in series with the base series capacitor (C5, C6).

5. Circuit according to any of the preceding claims, **characterized in that** no ohmic resistances are situated in an emitter path of a bipolar transistor (T1, T2).

6. Circuit according to any of the preceding claims, **characterized in that** the base connection lines of the bipolar transistors (T1, T2), in each case between the control transformer (TR1) and the bipolar transistor (T1, T2), are connected to one another by a base bridge capacitor (C3).

7. Circuit according to any of the preceding claims, **characterized in that** the base bridge capacitor (C3) has a capacitance of 100 pF to 220 pF.

8. Circuit according to any of the preceding claims, **characterized in that** the turn-on current for the bases of the bipolar transistors (T1, T2) amounts to 1.5 to 3 times the minimum turn-on current.

9. Circuit according to any of the preceding claims,
**characterized in that** a power negative feedback of the circuit arises as a result of a load current dependence of the operating frequency of the bipolar transistor bridge (T1, T2).

10. Circuit according to Claim 1, **characterized in that** the parallel resistor (R3, R4) also acts as a base protection resistor for the bipolar transistor (T1, T2).

11. Circuit according to Claim 1, **characterized in that** the parallel resistor (R3, R4) has a value of 100 Ω to 1000 Ω.

12. Circuit according to any of the preceding claims, **characterized in that** the bipolar transistor bridge is a half-bridge (T1, T2).

13. Circuit according to Claim 1, **characterized in that** the turns ratio of primary winding to secondary winding of the control transformer (TR1) is less than or equal to 1.

## Revendications

1. Circuit oscillateur pour faire fonctionner une charge, comprenant un pont ( T1, T2 ) de transistor bipolaire et un dispositif de commande de commutation sous la forme d'un transformateur ( TR1 ) de commande pour commander les bases des transistors ( T1, T2 ) bipolaires par une ligne respective de connexion de base, dans lequel un condensateur ( C5, C6 ) série de base est monté dans l'une des lignes de connexion de base entre le transformateur ( TR1 ) de commande et l'un des transistors ( T1, T2 ) bipolaires ou du côté du transistor ( TR1 ) de commande éloigné du transistor dans une ligne de connexion, en série à cela, du transformateur ( TR1 ) de commande en allant vers une prise ou un potentiel d'alimentation du pont ( T1, T2 ) de transistor bipolaire et, dans la ligne de connexion de base, il n'y a pas de composant à semi-conducteur, notamment de commutateur à semi-conducteur, en série avec le condensateur ( C5, C6 ) série de base entre le transformateur ( TR1 ) de base et le transistor ( T1, T2 ) bipolaire ou, du côté éloigné du transistor, dans la ligne de connexion, **caractérisé en ce qu'**en parallèle au circuit série composé du condensateur ( C5, C6 ) série de base et du transformateur ( TR1 ) de commande ou en parallèle au condensateur ( C5, C6 ) série de base est monté seulement une résistance ( R3, R4 ) en parallèle.

2. Circuit suivant la revendication 1, **caractérisé en ce que** le condensateur ( C5, C6 ) série de base a une capacité de 1µF à 4,7 µF.

3. Circuit suivant la revendication 1 ou 2, **caractérisé en ce que** dans la ligne de connexion de base entre le transformateur ( TR1 ) de commande et le transistor ( T1, T2 ) bipolaire ou, du côté éloigné du transistor, dans la ligne de connexion des résistances ohmiques ne sont pas montées en série au condensateur ( C5, C6 ) série de base.

4. Circuit suivant la revendication 1, 2 ou 3, **caractérisé en ce que** dans la ligne de connexion de base entre le transformateur ( TR1 ) de commande et le transistor ( T1, T2 ) bipolaire ou, du côté éloigné du transistor, dans la ligne de connexion des inductances ne sont pas montées en série avec le condensateur ( C5, C6 ) série de base.

5. Circuit suivant l'une des revendications précédentes, **caractérisé en ce que** des résistances ohmiques ne sont pas montées dans une section d'émetteur d'un transistor ( T1, T2) bipolaire.

6. Circuit suivant l'une des revendications précédentes, **caractérisé en ce que** les lignes de connexion de base des transistors ( T1, T2 ) bipolaires sont reliées entre elles respectivement entre le transformateur ( TR1 ) de commande et le transistor ( T1, T2 ) bipolaire par un condensateur ( C3 ) en pont de base.

7. Circuit suivant l'une des revendications précédentes, **caractérisé en ce que** le condensateur ( C3 ) en pont de base a une capacité allant de 100 pF à 220 pF.

8. Circuit suivant l'une des revendications précédentes, **caractérisé en ce que** le courant de polarisation des bases des transistors ( T1, T2 ) bipolaires représente de 1,5 à 3 fois le courant de polarisation minimum.

9. Circuit suivant l'une des revendications précédentes, **caractérisé en ce que**, par une variation du courant de charge, la fréquence de travail du pont ( T1, T2 ) de transistor bipolaire donne une contre réaction de puissance du circuit.

10. Circuit suivant la revendication 1, **caractérisé en ce que** la résistance ( R3, R4 ) en parallèle sert aussi de résistance de protection de la base pour le transistor ( T1, T2 ) bipolaire.

11. Circuit suivant la revendication 1, **caractérisé en ce que** la résistance ( R3, R4 ) en parallèle a une valeur de 100 Ω à 1000 Ω.

12. Circuit suivant l'une des revendications précédentes, **caractérisé en ce que** le pont de transistor bipolaire est un demi-pont ( T1, T2 ).

13. Circuit suivant la revendication 1, **caractérisé en ce que** le rapport d'enroulement primaire à secondaire du transformateur ( TR1 ) de commande est inférieur ou égal à 1.
